# EUROPEAN PATENT SPECIFICATION

(11) **EP 0 942 292 B1**
(45) Date of publication and mention of the grant of the patent: **29.06.2005**
(21) Application number: 99301696.3
(22) Date of filing: 08.03.1999
(51) Int. Cl.: G01R 31/02

(54) **Method of and apparatus for detecting cable oversheath faults and installations in which they are used**
Gerät und Verfahren zur Erfassung von Fehlern eines Kabelisolierungsmantels und Anlagen die sie benutzen
Procédé et appareil pour détecter des défauts de revêtement isolant et installations les utilisant

(30) Priority: 11.03.1998 GB 9805019
(43) Date of publication of application: 15.09.1999
(73) Proprietor: Pirelli Cables (2000) Limited, London W1K 4QZ (GB)
(72) Inventor: Endersby, Timothy Mark, Plumstead, London SE18 7QA (GB); Gregory, Brian Mark, Dartford, Kent DA1 3JW (GB)
(74) Representative: Abbie, Andrew Kenneth

(56) References cited:
- WO-A-97/17616
- DE-A- 4 100 037
- US-A- 3 365 665
- PATENT ABSTRACTS OF JAPAN vol. 1997, no. 03, 31 March 1997 (1997-03-31) -& JP 08 304487 A (HITACHI CABLE LTD), 22 November 1996 (1996-11-22)
- PATENT ABSTRACTS OF JAPAN vol. 014, no. 376 (P-1092) 14 August 1990 & JP 02 141 676 A (FUJIKURA LTD) 31 May 1990

## Description

This invention relates to a method of and apparatus for detecting oversheath faults in electric power cables and to the installations in which they are used.

Cable installations for the transmission of bulk power are usually made with single-core cables with metal sheaths or other forms of earth-return conductors, which are usually covered with an electrically insulating oversheath (or jacket), usually of plastics material, both to avoid uncontrolled earthing (grounding) and to protect the return conductor from corrosion.

Undetected damage resulting in perforation of the oversheath can lead to quite rapid corrosion of the return conductor and, (where applicable if the metal sheath is perforated), to electrical failure of the primary insulation and serious consequential damage (as several megawatts of power may be discharged into the fault in the time it takes for protective devices to isolate it), making the circuit unavailable for service until repairs can be completed.

Since the cable sheath is earthed in one or more positions, continuity testing in service is not possible, and it is current practice to withdraw cable installations from service, disconnect their normal earth connections, and test section-by section before restoring normal operation . In a large installation with earth connections in joint bays distributed along the route, this procedure can require an "outage", in which the installation is not available for use, measured in days or weeks, and it is impracticable to repeat the procedure frequently - an interval of as much as a year is sometimes recommended, and even that is not always adhered to. Such infrequent testing really cannot give any realistic assurance of freedom from the sort of damage that may be done (for instance) by rodents, termites, or mechanical excavators.

It is the object of the present invention to provide techniques by which testing can be performed with the cable installation in service and therefore at much more frequent intervals, or even continuously or substantially so.

The invention is based on the recognition that the earth circuit of the cable (by which is meant the metal sheath or other earth return conductor plus the leads interconnecting them to each other and to earthing points and associated voltage limiters) will usually carry some induced currents. The induced voltage flows to earth, normally only at the earth connections provided, but abnormally also through the fault in the oversheath, with the result that the fault in the oversheath will be indicated, in principle, by a change in the current flowing in the earth circuit.

It will be readily apparent that merely detecting change in current in the earth circuit will not suffice, since it will also vary from other causes: to start with, it will vary in proportion to the load current in the cable (or the individual phase with which it is associated, where the phases may be unequally loaded). In consequence, the temperature of the sheath, and other parts of the earth circuit, will vary in proportion to the square of the load current (once stabilised under constant load conditions). Each might also be influenced by various transient and external events (even passing trains, if it is adjacent to an electric railway (or railroad).

The Patent Abstracts of Japan abstract for JP-A-02141676 discloses a method of detecting oversheath faults in a metal-sheathed power cable installation comprising continuously making measurements of the level of current flowing through the earth circuit while the installation is in service; making a comparison between those measurements and a normal current level in the absence of oversheath faults; and generating an output signal if the difference between the measured current level and normal current level is higher than a specified value.

The invention provides a method of detecting oversheath faults in a metal-sheathed power cable installation comprising making measurements representative of the current at at least one point in the earth circuit of the cable while the installation is in service; making a comparison between those measurements and comparator values related, as the measurements are expected to be in the absence of oversheath faults, to the load current; and generating an output signal if the measurements differ from the comparator values, characterised by obtaining said comparator values using a learning phase in which the range of changes in such measurements is observed while the installation is free of oversheath faults and thereafter making said comparison by monitoring said measurements representative of current to indicate if a change outside that range occurs.

The comparator values may, if necessary, take account of other factors that might influence the measurements.

The measurements may be made at appropriate points on the metal cable sheath itself, or on other return conductors if there is no sheath, but these are most susceptible to interference from the cable temperature and other influences, and we prefer to make measurements at points on bonding conductors, voltage limiters and/or direct earth leads that are spaced from the cable itself.

The measurements might in some cases be measurements made at least one different point in the earth circuit.

So, for example, in a well-balanced cross-bonded installation, the cross-bonding position should be expected to carry substantially the same current, in the absence of a fault, and on comparing the currents in pairs any substantial difference is likely to indicate an oversheath fault, or at least an occurrence indicating that the possibility of such a fault should be investigated; useful comparisons can also be made between one bonding position (cable joint bay) and the next.

Voltage limiters in earth circuits of cable installations do not carry current in steady load conditions, and useful measurements can only be made on them on the occurrence of system disturbances such as switching transients; but in some installations these may occur frequently enough to be useful, and measurements at voltage limiters may be less susceptible than those made elsewhere to other factors.

Depending on the design of the installation and other circumstances, the measurements representative of the current in the earth circuit may be of various kinds: for instance, they may be voltages (or currents) induced in current transformers magnetically linked with the relevant earth circuit (broadly as for an earth-leakage circuit breaker). Hall effect devices can also be used. Especially where there are multiple measurements to be made, we prefer entirely passive measurements so as not to require the provision of electrical power at the places to be monitored or the provision of protection from electrical transients. Most especially, we prefer to measure the temperature of the earth conductor itself (which varies with the current flowing through it in a well-established way) or the temperature of a ferromagnetic body adjacent to it, preferably by the use of optical fibre temperature sensors wrapped round or otherwise closely associated with the respective body, or in appropriate cases incorporated within it. Raman backscatter detectors or optical point detectors can be used - point detectors are expected to have a substantially greater range. Alternatively, other, preferably passive, temperature (or current) detectors may be observed by fibre-optic techniques - for example, a bimetal strip might be bonded to the earth conductor and carry a banded scale which can be remotely observed via an optical fibre.

Various earth-bonding options are in use, and the invention is applicable to all of them. In a simple end-point or mid-point earthed system, there may be only one group of earth connecting leads where measurements can reasonably be made; in a system with multi-point earthing with all the sheaths connected together at each earthing point, it will be preferable for measurements to be made at all, or at least many, of the earthing points; and in a cross-bonded system, measurements may be made at some or all of the cross-bonding conductors or the eventual earth conductor(s) or at both of these; the more measurements available, the better the opportunities for recognising patterns and distinguishing between them, but the greater the amount of computation required.

Ideally, measurements should be made and monitored continuously or at regular intervals of minutes or hours. In this case, very large amounts of data will be obtained, and it may be preferable to process it, without intellectual analysis, using neural network computational techniques (in which a computer adjusts multiple parameters in a highly complex function to obtain a match with the input observations).

Alternatively, measurements may be taken, or at least may be used in computation, only when the conditions make the computations easier: for example, only when the load current has been substantially constant (perhaps at one of a limited number of pre-selected levels) for a pre-set length of time (several days) so that temperatures in the cable will have stabilised. Under these conditions, the normal earth currents will be relatively constant and faults more easily apparent. Provided the chosen conditions recur with reasonable frequency (even over several months) this approach still gives useful warning of risk of failure, at least compared with current practice (a sudden fault is probably due to an extreme cause, such as mechanical excavator, that is liable in any event to perforate the cable sheath before any avoiding action can be taken).

While it may be reasonable to assume that a newly installed cable will be free of oversheath faults for the first several months, it is desirable to conduct conventional fault-detection tests (with sections of sheath isolated and energised at around 5kV) before and after the learning stage, to ensure it is indeed carried out under fault-free conditions.

The invention also includes an installation provided with apparatus for detecting oversheath faults in the installation, said apparatus comprising means for making measurements representative of the current at at least one point in the earth circuit of the cable while the installation is in service; means for making a comparison between those measurements and comparator values related, as the measurements are expected to be in the absence of oversheath faults, to the load current; and means for generating an output signal if the measurements differ from the comparator values, characterised by means for storing and analysing data during a learning phase while the installation is free of oversheath faults for determining a range of variations of said measurements as comparator values, and by said means for making a comparison monitoring said measurements made white the installation is in service to indicate if a change outside that range occurs.

The comparator values may, if necessary, take account of other factors that might influence the measurements.

The means for making the said measurements may comprise means for making the said measurements at least one different point in the earth circuit.

The storing and analysing means may comprise means for determining said range of variations on the basis of measurements made at least one different point in the earth circuit during said learning phase.

The said different points may be corresponding bonding leads at the next bonding position.

When the installation is balanced cross-bonded cable installation, said means for making the said measurements is arranged to make said measurements at different cross-bonding leads at one cross-bonding position.

The means for making the said measurements may comprise means for making measurements representative of current through voltage limiters in the said earth circuits on the occurrence of switching transients.

The means for making the said measurements may be temperature sensing means.

The temperature sensing means may be optical fibre temperature sensors.

The means for making the said measurements may be Hall effect devices.

The invention will be further described, by way of example, with reference to the accompanying drawings in which:
Figure 1 is a diagrammatic representation of several variant forms of the invention and
Figure 2 is a similar representation of another part of one important form of the invention.

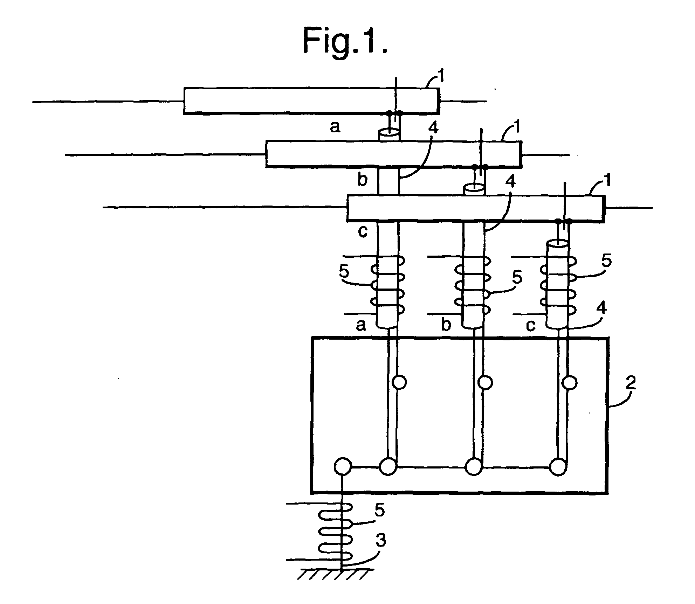

Figure 1 represents systems of earthing without cross-bonding and may, according to the type of earthing represent the upstream or downstream end of the cable installation, its mid-point or multiple points along its length. It also represents those places in a cross-bonded installation where actual earth connections are normally made. In each case, the metal sheaths 1, 1, 1 of the three phases a, b, c of the installation are connected (in a conventional way) to separate terminals in a link box 2 which permits them to be connected to a common earth lead 3 (during service) or disconnected from it (for conventional testing of the oversheath). The individual earth leads 4 are shown as being concentric, which is the most usual way of ensuring adequate control of the very high transient voltages that may arise; however, separate leads for the two sides of the earth circuit could be used. In applying the invention to these example installations, optical fibre temperature sensors 5 are wrapped around, or incorporated into the metallic conductor(s) of, the common earth lead 3 and/or the individual earth leads 4 of the individual phases.

The common earth lead 3 normally carries little or no current, and so its temperature is the most sensitive indicator of the occurrence of a fault; on the other hand, the temperatures of the individual earth conductors 4 will vary depending on the particular phase on which a fault may occur, and by making measurements on these conductors the faulted return conductor section or phase may be predicted and location of a fault after its occurrence has been detected accelerated.

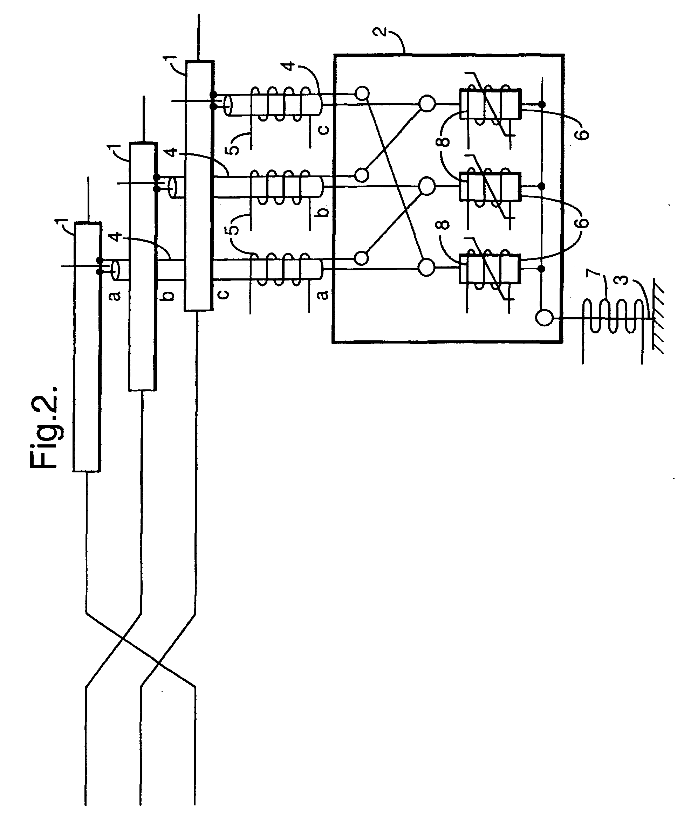

Figure 2 shows, for an installation in which the sheaths of the individual phases are sectionalised and crossbonded, at one of the cross-bonding positions. Here also, the sheaths 1 are individually connected to corresponding terminals of a link box 2 by individual (usually concentric) leads 4 but the terminals in the link box are interconnected so that adjacent lengths of sheath of different phases of the installation are connected in series, so balancing the installation and minimising overall sheath currents. Another terminal is connected to earth by a common earth lead 3, but in this case the latter is provided only for earthing the link box itself and, if sheath voltage limiters 6 are star-connected, for earthing the star point. Hence the common earth lead 3 will not normally carry current while the cable is in service but may do so when voltage transients occur. In this case, optical fibre temperature detectors 5 applied to the individual conductors 4 will again give useful data allowing phase and section predictions to be made of the location of any fault detected and, alternatively or in addition, useful data can be obtained when sheath voltage transients occur from optical fibre temperature sensors 7 and 8 respectively wound on the common earth lead 3 and the sheath voltage limiters 6. These voltage limiters are substantially insulating under normal conditions but switch to a low resistance state at high voltages (say around 6kV), whereupon a high current may flow for a short period, producing a temperature pulse. In case of an oversheath fault, part of the pulse current will be shunted through the fault and the size of the temperature pulse will be reduced.

In those forms of the invention in which temperature measurements are made (but preferably excluding any in which the temperature measured is in the cable itself), thermal insulation may be used to increase temperature rise and so the sensitivity of the measurements; for example, in the examples shown in the drawings, the regions of the optical fibre wrappings may be enveloped in polyurethane foam (preferably a low-strength composition if in positions where access may be needed during testing operations or otherwise) or over-wrapped with flexible thermal insulating material.

## Claims

1. A method of detecting oversheath faults in a metal-sheathed power cable installation comprising making measurements representative of the current at at least one point in the earth circuit of the cable while the installation is in service; making a comparison between those measurements and comparator values related, as the measurements are expected to be in the absence of oversheath faults, to the load current; and generating an output signal if the measurements differ from the comparator values, **characterised by** obtaining said comparator values using a learning phase in which the range of changes in such measurements is observed while the installation is free of oversheath faults and thereafter making said comparison by monitoring said measurements representative of current to indicate if a change outside that range occurs.

2. A method as claimed in claim 1 comprising making the measurements at points on bonding conductors, voltage limiters and/or direct earth leads that are spaced from the cable itself.

3. A method as claimed in claim 1 or 2, in which said measurements are made at least one different point in the earth circuit.

4. A method as claimed in claim 3, applied to a balanced cross-bonded cable installation in which said measurements are obtained from different cross-bonding leads at any one cross-bonding position.

5. A method as claimed in claim 3, in which the said different points are on corresponding bonding leads at the next bonding position.

6. A method as claimed in any one of the preceding claims, comprising making said measurements representative of current through voltage limiters in the said earth circuits on the occurrence of switching transients.

7. A method as claimed in any one of the preceding claims, in which the measurements representative of the current in the earth circuit are measurements of the temperature of the earth conductor or of a ferromagnetic body adjacent to it.

8. A method as claimed in claim 7, in which the temperatures are measured by the use of optical fibre temperature sensors.

9. A method as claimed in any one of claims 1 to 6, in which the measurements representative of the current in the earth circuit are measurements of a magnetic field generated by the said current and detected by a Hall effect device.

10. A method as claimed in any one of the preceding claims, comprising making said measurements representative of current and making said comparison between the measurements and comparator values continuously.

11. A method as claimed in claim 10, comprising using neural network computational techniques.

12. A method as claimed in any one of claims 1 to 10, in which said measurements are used in computation only when the load current has been substantially constant for a pre-set length of time.

13. A power cable installation provided with apparatus for detecting oversheath faults in the installation, said apparatus comprising means (5, 8) for making measurements representative of the current at at least one point in the earth circuit of the cable while the installation is in service; means for making a comparison between those measurements and comparator values related, as the measurements are expected to be in the absence of oversheath faults, to the load current; and means for generating an output signal if the measurements differ from the comparator values, **characterised by** means for storing and analysing data during a learning phase while the installation is free of oversheath faults for determining a range of variations of said measurements as comparator values, and by said means for making a comparison monitoring said measurements made while the installation is in service to indicate if a change outside that range occurs.

14. An installation as claimed in claim 13, wherein said means for making the said measurements comprises means for making the said measurements at points on bonding conductors, voltage limiters (6) and/or direct earth leads (3, 4) that are spaced from the cable itself.

15. An installation as claimed in claim 13 or 14, wherein said means for making measurements comprises means for making the said measurements at least one different point in the earth circuit.

16. An installation as claimed in claim 15, wherein said storing and analysing means comprises means for determining said range of variations on the basis of measurements made at least one different point in the earth circuit during said learning phase.

17. An installation as claimed in claim 15 or 16, wherein the installation is a balanced cross-bonded cable installation and said means for making the said measurements is arranged to make said measurements at different cross-bonding leads at one cross-bonding position.

18. An installation as claimed in claim 15 or 16, in which the said different points are on corresponding bonding leads at the next bonding position.

19. An installation as claimed in any one of claims 13 to 18, wherein the means for making the said measurements comprise means (8) for making measurements representative of current through voltage limiters (6) in the said earth circuits on the occurrence of switching transients.

20. An installation as claimed in any one of claims 13 to 19, in which the means for making the said measurements are temperature measuring means (5, 8).

21. An installation as claimed in claim 20, in which the said temperature sensing means are optical fibre temperature sensors (5, 8).

22. An installation as claimed in any one of claims 13 to 19, in which the means for making the said measurements are Hall effect devices.

## Patentansprüche

1. Verfahren zum Feststellen von Ummantelungsfehlern in einer metallumhüllten Starkstromkabelanordnung, bei dem repräsentative Messungen für die Stromstärke an zumindest einem Punkt in der Erdschleife des Kabels gemacht werden, während die Anordnung in Betrieb ist, und bei dem ein Vergleich zwischen diesen Messungen und auf die Laststromstärke bezogenen Vergleichswerten, die aufgenommen wurden, als davon ausgegangen werden konnte, dass keine Ummantelungsfehler vorhanden waren, durchgeführt werden, und bei dem ein Ausgabesignal erzeugt wird, falls die Messungen von den Vergleichswerten abweichen, **dadurch gekennzeichnet, dass** die Vergleichswerte erhalten werden, in dem eine Lernphase verwendet wird, in der die Bandbreite der Änderungen in den Messungen überwacht wird, während die Anordnung frei von Ummantelungsfehlern ist, und dass im Anschluss daran der Vergleich durchgeführt wird, in dem die die Stromstärke repräsentierenden Messungen überwacht werden, um anzuzeigen, falls eine Änderung außerhalb dieser Bandbreite auftritt.

2. Verfahren nach Anspruch 1, **dadurch gekennzeichnet, dass** die Messungen an Punkten von Verbindungsleitern, Spannungsbegrenzern und/oder direkten Erdungsanschlüssen, die von dem Kabel selbst beabstandet sind, durchgeführt werden.

3. Verfahren nach Anspruch 1 oder 2, bei dem die Messungen an zumindest einem unterschiedlichen Punkt in der Erdschleife durchgeführt werden.

4. Verfahren nach Anspruch 3, welches auf eine symmetrische querverbundene Kabelanordnung angewendet wird, bei dem die Messungen von unterschiedlichen Querverbindungsleitern an irgend einer Querverbindungsposition erhalten werden.

5. Verfahren nach Anspruch 3, bei dem sich die unterschiedlichen Punkte sich auf korrespondierenden Verbindungsleitern an der nächsten Verbindungsposition befinden.

6. Verfahren nach einem der vorherigen Ansprüche, wobei die die Stromstärke repräsentierenden Messungen durch Spannungsbegrenzer in der Erdschleife beim Auftreten von Schaltstößen gemacht werden.

7. Verfahren nach einem der vorherigen Ansprüche, bei dem die die Stromstärke in der Erdschleife repräsentierenden Messungen Messungen der Temperatur des Erdleiters oder eines ferromagnetischen Körpers nahe bei diesem sind.

8. Verfahren nach Anspruch 7, bei dem die Temperaturen durch die Verwendung von Glasfasertemperatursensoren gemessen werden.

9. Verfahren nach einem der Ansprüche 1 bis 6, bei dem die die Stromstärke in der Erdschleife repräsentierenden Messungen Messungen eines durch die Stromstärke erzeugten magnetischen Felds sind und durch ein Halleffektmessgerät ermittelt werden.

10. Verfahren nach einem der vorherigen Ansprüche, bei dem die die Stromstärke repräsentierenden Messungen und das Vergleichen zwischen diesen Messungen und den Vergleichswerten kontinuierlich erfolgt.

11. Verfahren nach Anspruch 10, bei dem neurale Netzwerkberechnungsmethoden verwendet werden.

12. Verfahren nach einem der Ansprüche 1 bis 10, bei dem die Messungen zur Berechnung nur verwendet werden, wenn die Laststromstärke für eine festgesetzte Zeitlänge im Wesentlichen konstant war.

13. Starkstromkabelanordnung versehen mit einer Vorrichtung zur Ermittlung von Ummantelungsfehlern in der Anordnung, wobei die Vorrichtung Mittel (5,8) zum Durchführen von die Stromstärke an zumindest einem Punkt in der Erdschleife des Kabels repräsentierenden Messungen, während die Anordnung in Betrieb ist, Mittel zum Durchführen eines Vergleichs zwischen diesen Messungen und auf die Laststromstärke bezogenen Vergleichswerten, während für die Messungen das Fehlen von Ummantelungsfehlern angenommen werden kann und Mittel zum Erzeugen eines Ausgabesignals aufweist, falls die Messungen von den Vergleichswerten abweichen, **dadurch gekennzeichnet, dass** Mittel zum Speichern und Analysieren von Daten während einer Lernphase, bei der die Anordnung frei von Ummantelungsfehlern ist, um eine Bandbreite von Variationen der Messungen als Vergleichswerte festzustellen, vorhanden sind, und dass Mittel zum Durchführen eines Vergleichs vorhanden sind, um die gemachten Messungen zu überwachen, während die Anordnung in Betrieb ist, um anzuzeigen, falls eine Änderung außerhalb der Bandbreite auftritt.

14. Anordnung nach Anspruch 13, **dadurch gekennzeichnet, dass** die Mittel zur Durchführung der Messungen Mittel zum Durchführen der Messungen an Punkten auf den Verbindungsleitern, Spannungsbegrenzern (6) und/oder direkten Erdanschlüssen (3,4), die von dem Kabel selbst beabstandet sind, aufweisen.

15. Anordnung nach Anspruch 13 oder 14, **dadurch gekennzeichnet, dass** die Mittel zum Durchführen der Messungen Mittel zum Durchführen der Messungen an zumindest einem unterschiedlichen Punkt in der Erdschleife aufweisen.

16. Anordnung nach Anspruch 15, **dadurch gekennzeichnet, dass** die Speicher- und Analysiermittel Mittel zum Bestimmen einer Bandbreite von Variationen auf der Basis der Messungen, die an zumindest einem unterschiedlichen Punkt in der Erdschleife während der Lernphase durchgeführt wurden, aufweisen.

17. Anordnung nach Anspruch 15 oder 16, **dadurch gekennzeichnet, dass** die Anordnung eine symmetrische querverbundene Kabelanordnung ist und die Mittel zum Durchführen der Messungen derart angeordnet sind, um die Messungen an unterschiedlichen Querverbindungsleitern an einer Querverbindungsposition durchzuführen.

18. Anordnung nach Anspruch 15 oder 16, bei der die unterschiedlichen Punkte auf korrespondierenden Verbindungsleitern an der nächsten Verbindungsposition befinden.

19. Anordnung nach einem der Ansprüche 13 bis 18, **dadurch gekennzeichnet, dass** die Mittel zum Durchführen der Messungen Mittel (8) zum Aufnehmen von die Stromstärke repräsentierenden Messungen durch Spannungsbegrenzer (6) in der Erdschleife bei dem Auftreten von Schaltstößen aufweisen.

20. Anordnung nach einem der Ansprüche 13 bis 19, bei dem die Mittel zum Durchführen der Messungen Temperaturbestimmungsmittel (5,8) sind.

21. Anordnung nach Anspruch 20, bei dem die Temperaturbestimmungsmittel Glasfasertemperatursensoren (5,8) sind.

22. Anordnung nach einem der Ansprüche 13 bis 19, bei dem die Mittel zum Durchführen der Messungen Halleffektmessgeräte sind.

## Revendications

1. Procédé de détection de défauts de gaine externe dans une installation de câble électrique à gaine métallique comprenant le fait de prendre des mesures représentatives du courant en au moins un point du circuit de terre du câble pendant que l'installation est en service, faire une comparaison entre ces mesures et des valeurs de comparateur se rapportant, puisque les mesures sont censées être faites en l'absence de défauts de gaine externe, au courant de charge, et générer un signal de sortie si les mesures diffèrent des valeurs de comparateur, **caractérisé en ce que** l'on obtient lesdites valeurs de comparateur en utilisant une phase d'apprentissage dans laquelle la plage de variation de ces mesures est observée pendant que l'installation est exempte de défauts de gaine externe puis en effectuant ladite comparaison en surveillant lesdites mesures représentatives du courant pour indiquer s'il se produit une variation en dehors de cette plage.

2. Procédé selon la revendication 1, comprenant le fait de prendre les mesures en des points situés sur des conducteurs de métallisation, des limiteurs de tension et/ou des conducteurs de terre directs qui sont espacés par rapport au câble.

3. Procédé selon la revendication 1 ou 2, dans lequel lesdites mesures sont prises en au moins un point différent dans le circuit de terre.

4. Procédé selon la revendication 3, appliqué à une installation de câble permuté équilibrée, dans lequel lesdites mesures sont obtenues à partir de différents conducteurs de permutation en n'importe quelle position de permutation.

5. Procédé selon la revendication 3, dans lequel lesdits différents points sont sur des conducteurs de métallisation correspondants à la position de métallisation suivante.

6. Procédé selon l'une quelconque des revendications précédentes, comprenant le fait de prendre lesdites mesures représentatives du courant traversant des limiteurs de tension dans lesdits circuits de terre lors de l'apparition de transitoires de commutation.

7. Procédé selon l'une quelconque des revendications précédentes, dans lequel les mesures représentatives du courant circulant dans le circuit de terre sont des mesures de la température du conducteur de terre ou d'un corps ferromagnétique voisin de celui-ci.

8. Procédé selon la revendication 7, dans lequel les températures sont mesurées en utilisant des capteurs de température à fibre optique.

9. Procédé selon l'une quelconque des revendications 1 à 6, dans lequel les mesures représentatives du courant circulant dans le circuit de terre sont des mesures d'un champ magnétique produit par ledit courant et détecté par un dispositif à effet Hall.

10. Procédé selon l'une quelconque des revendications précédentes, comprenant le fait de prendre lesdites mesures représentatives du courant et d'effectuer ladite comparaison entre les mesures et les valeurs de comparateur de manière continue.

11. Procédé selon la revendication 10, comprenant le fait d'utiliser des techniques de calcul à réseau neuronal.

12. Procédé selon l'une quelconque des revendications 1 à 10, dans lequel lesdites mesures sont utilisées dans les calculs uniquement lorsque le courant de charge a été sensiblement constant pendant un intervalle de temps prédéterminé.

13. Installation de câble électrique pourvue d'un appareil permettant de détecter les défauts de gaine externe dans l'installation, ledit appareil comprenant un moyen (5, 8) servant à prendre des mesures représentatives du courant en au moins un point du circuit de terre du câble pendant que l'installation est en service, un moyen servant à faire une comparaison entre ces mesures et des valeurs de comparateur se rapportant, puisque les mesures sont censées être faites en l'absence de défauts de gaine externe, au courant de charge, et un moyen servant à générer un signal de sortie si les mesures diffèrent des valeurs de comparateur, **caractérisée par** un moyen servant à stocker et analyser des données au cours d'une phase d'apprentissage pendant que l'installation est exempte de défauts de gaine externe pour déterminer une plage de variation desdites mesures en tant que valeurs de comparateur, et par ledit moyen servant à faire une comparaison qui surveille lesdites mesures prises pendant que l'installation est en service pour indiquer s'il se produit une variation en dehors de cette plage.

14. Installation selon la revendication 13, dans laquelle ledit moyen servant à prendre lesdites mesures comprend un moyen servant à prendre lesdites mesures en des points situés sur des conducteurs de métallisation, des limiteurs de tension (6) et/ou des conducteurs de terre directs (3, 4) qui sont espacés par rapport au câble.

15. Installation selon la revendication 13 ou 14, dans laquelle ledit moyen servant à prendre des mesures comprend un moyen servant à prendre lesdites mesures en au moins un point différent dans le circuit de terre.

16. Installation selon la revendication 15, dans laquelle ledit moyen de stockage et d'analyse comprend un moyen servant à déterminer ladite plage de variations d'après les mesures prises en au moins un point différent dans le circuit de terre pendant ladite phase d'apprentissage.

17. Installation selon la revendication 15 ou 16, dans laquelle l'installation est une installation de câble permuté équilibrée, et ledit moyen servant à prendre lesdites mesures est adapté pour prendre lesdites mesures sur différents conducteurs de permutation en une position de permutation.

18. Installation selon la revendication 15 ou 16, dans laquelle lesdits différents points sont sur des conducteurs de métallisation correspondants à la position de métallisation suivante.

19. Installation selon l'une quelconque des revendications 13 à 18, dans laquelle le moyen servant à prendre lesdites mesures comprend un moyen (8) servant à prendre des mesures représentatives du courant circulant dans des limiteurs de tension (6) dans lesdits circuits de terre lors de l'apparition de transitoires de commutation.

20. Installation selon l'une quelconque des revendications 13 à 19, dans laquelle le moyen servant à prendre lesdites mesures sont des moyens de mesure de température (5, 8).

21. Installation selon la revendication 20, dans laquelle lesdits moyens de mesure de température sont des capteurs de température à fibre optique (5, 8).

22. Installation selon l'une quelconque des revendications 13 à 19, dans laquelle le moyen servant à prendre lesdites mesures sont des dispositifs à effet Hall.
